# EUROPEAN PATENT APPLICATION

(11) **EP 3 675 295 A1**
(43) Date of publication of application: **01.07.2020**
(21) Application number: 18306875.8
(22) Date of filing: 28.12.2018
(51) Int. Cl.: H01S 5/024, H01S 5/068, H01S 5/022, H01S 5/026, H01S 5/042, H01S 5/06, H01S 5/12, H01S 5/227, H01S 5/22

(54) **LASER ASSEMBLIES**

(71) Applicant: Nokia Solutions and Networks Oy, 02610 Espoo (FI)
(72) Inventor: DEBREGEAS, Hélène, 78150 Paris (FR); MEKHAZNI, Karim, 91250 Paris (FR)
(74) Representative: Bryers LLP

(57) **Abstract**

A laser assembly comprises a semiconductor laser mounted on a sub-mount, a heating element, a thermoelectric device, and a mounting structure to receive the semiconductor laser, the mounting structure disposed between the semiconductor laser and the thermoelectric device to reduce a thermal conductivity between the semiconductor laser and the thermoelectric device.

## Description

### TECHNICAL FIELD

Aspects relate, in general, to laser assemblies.

### BACKGROUND

To increase overall capacity, wireless telecommunication access networks are evolving towards NG-PON2 (Next Generation Passive Optical Networks). An approach that can be used in such an evolution is TWDM-PON (Time and Wavelength Division Multiplexing - Passive Optical Networks), which is based on burst-mode operation and which uses tuning of laser sources at both the user and network side over, for example, 4 × 100GHz-spaced channels, or 8 × 50GHz-spaced channels, thereby corresponding to an overall tuning over 400GHz (2.4nm). Tuneable laser sources for such networks can be based on thermal tuning of single-mode directly modulated Distributed Feedback (DFB) laser or Externally Modulated Lasers (EMLs).

### SUMMARY

According to an example, there is provided a laser assembly comprising semiconductor laser mounted on a sub-mount, a heating element, a thermoelectric device, and a mounting structure to receive the semiconductor laser, the mounting structure disposed between the semiconductor laser and the thermoelectric device to reduce a thermal conductivity between the semiconductor laser and the thermoelectric device. The mounting structure can define an air gap between the semiconductor laser and the sub-mount, thereby reducing thermal conductivity between the semiconductor laser and the thermoelectric device. The mounting structure can comprise multiple thermally conductive protrusions extending from the sub-mount. The mounting structure can comprise at least one indentation, groove or channel in the sub-mount, at least an edge of which is configured to support the semiconductor laser. The heating element can comprise a resistive heating element. The heating element can comprise a diode. The thermoelectric device can comprise a Peltier device. The heating element can be provided in a waveguide of the semiconductor laser. A temperature sensor can be used to measure a temperature of the semiconductor laser or sub-mount.

According to an example, there is provided a method for tuning a modulated laser assembly, the method comprising modifying an operating temperature of a semiconductor laser of the laser assembly using first and second heating devices, the operating temperature comprising first and second temperature components, wherein the first heating device is configured to modify the first component of the temperature of the semiconductor laser over a first time period, and wherein the second heating device is configured to modify the second component of the temperature of the semiconductor laser over a second time period. The second time period can be less than the first time period. The first component of the temperature of the semiconductor laser can be modified using a thermoelectric device. The second component of the temperature of the semiconductor laser can be modified using a heating element arranged on the semiconductor laser. A temperature sensor can be used to measure the operating temperature of the semiconductor laser. A current supply to the first and/or second heating devices can be varied so as to modify a heating output thereof.

### BRIEF DESCRIPTION OF THE DRAWINGS

Embodiments will now be described, by way of example only, with reference to the accompanying drawings, in which:
Figures Ia and Ib are examples of tuning structures;
Figure 2 is a schematic representation of a laser assembly;
Figure 3 is a schematic representation of a laser assembly according to an example;
Figure 4a is a schematic representation of two implementations of a heater along a laser waveguide according to some examples;
Figures 4b is a schematic representation of a fake diode implementation according to an example;
Figure 5 is a schematic representation of the principle of fast tuning according to an example;
Figure 6 shows a graph depicting required electrical power to tune and laser self-heating in standard operation as a function of laser thermal resistance according to an example;
Figures 7a-c are schematic representations of examples of a mounting structure;
Figure 8 is a graph depicting variation of laser wavelength drift as a function of injected current for different mounting structures according to examples; and
Figure 9 shows a pair of plots depicting tuning with 330mW injected power into a heating element according to an example.

### DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Figures Ia and Ib are examples of tuning structures. For fast laser tuning, one solution (figure la) is based on an electrically-tuneable laser such as a DBR (Distributed Bragg Reflector laser), comprising an active section 101, a phase section 103, and a passive section with a Bragg grating 105 for tuning. These devices are more complex to fabricate and to control than a standard DFB laser, and are hardly compliant with the spectral specifications of NGPON2 (e.g. side-mode suppression ratio >50dB).

Another approach (figure Ib) is based on an array of 4 (or 8) DFB lasers 107 with a combiner 109, and (optionally) an output amplifier. Tuning is obtained by turning on the laser with required wavelength, and keeping the other lasers off. This solution is expensive and bulky.

According to an example, there is provided a method for fast thermal tuning of a laser assembly that uses a heater close to the laser waveguide to provide fast tuning, and a thermoelectric device that provides progressive heating or cooling. The thermoelectric device can be a Peltier device for example. In an example, there is provided an increase in laser thermal resistance, so as to provide efficient operation of the heater, by using a mounting structure disposed between the semiconductor laser and the thermoelectric device to reduce a thermal conductivity between the semiconductor laser and the thermoelectric device. In an example, the mounting structure can be used to provide air-gap between the semiconductor laser and a sub-mount.

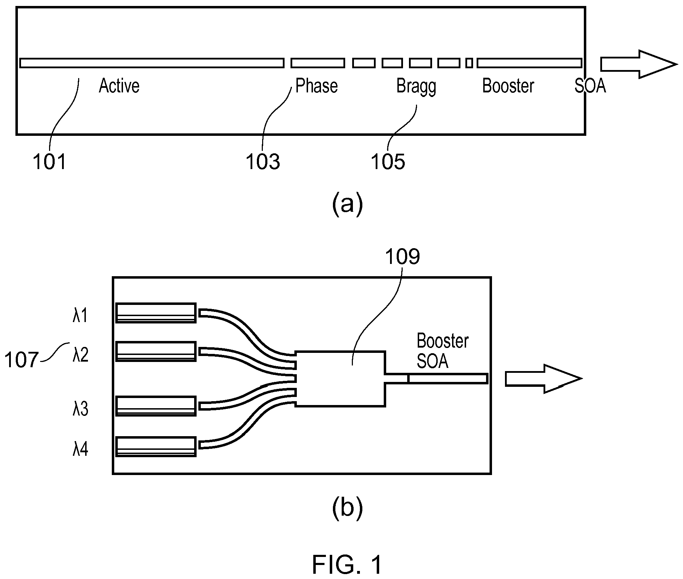

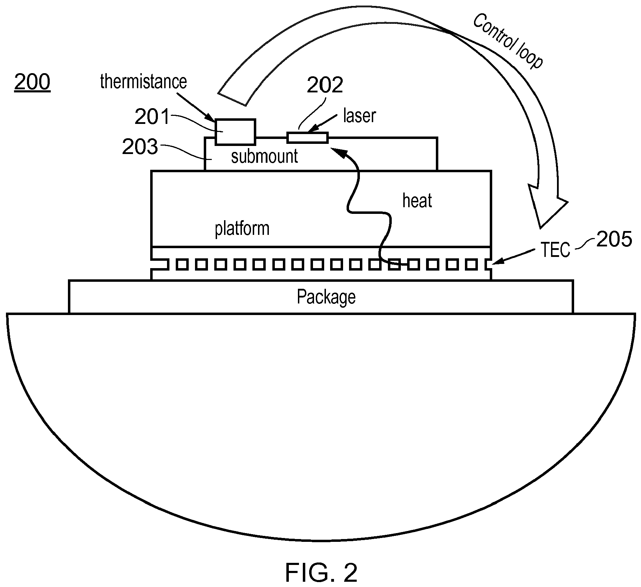

Figure 2 is a schematic representation of a laser assembly. Laser 202 temperature is measured using a thermistor 201 attached to the submount 203, and which is controlled by a Peltier Thermo-Electric Cooler (TEC) 205 positioned in the package 200. Due to the large volume between the TEC 205 and the laser 202, heating via the TEC 205 is relatively slow (∼1s), corresponding to overall stabilisation of heat flux.

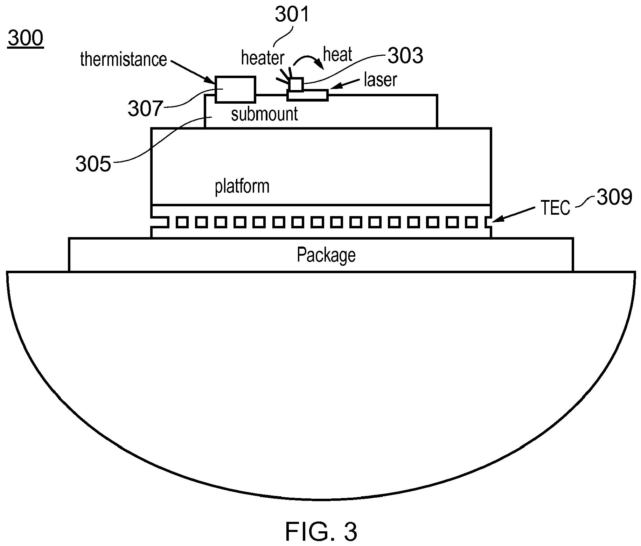

Figure 3 is a schematic representation of a laser assembly according to an example. A heater 301 is provided. The heater 301 can be integrated on the semiconductor chip. In the example of figure 3, the heater 301 is provided close to a laser 303 waveguide (described in more detail below). Similarly to figure 2, laser 303 temperature is measured using a thermistor 307 attached to the submount 305 of the assembly 300. A Thermo-Electric Cooler (TEC) 309 is positioned in the package 300. Heater 301 provides a fast heating of the laser 303, whereas TEC 309 provides a relatively slower heating (or cooling) of the laser 303.

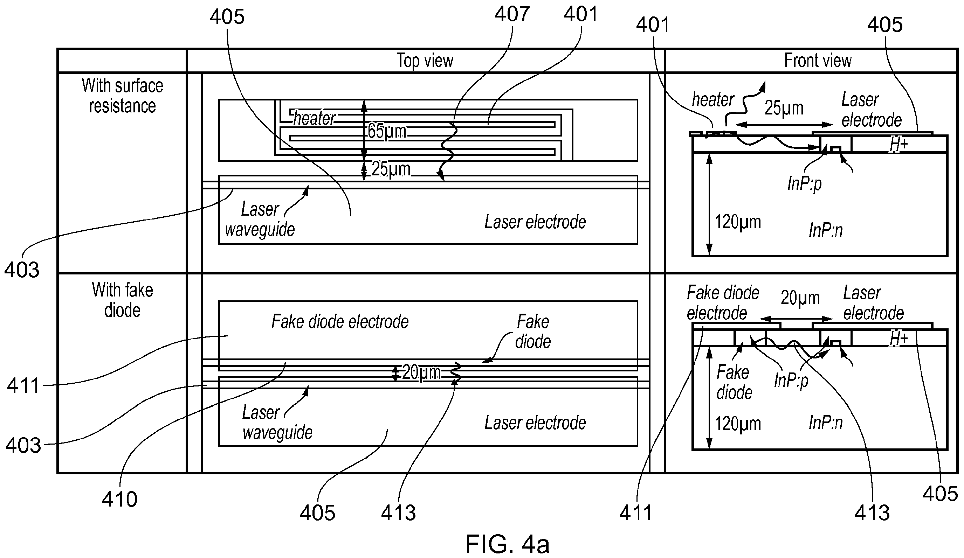

Figure 4a is a schematic representation of two implementations of a heater along a laser waveguide according to some examples. Figure 4a shows top and front views of a portion of a laser assembly with two different heater implementations according to examples: surface resistance and a 'fake' diode. In both cases, in example, the distance between a heater and the laser is reduced to a few tens of microns. Thermal dissipation time is very short, leading to fast heating (of a few milliseconds).

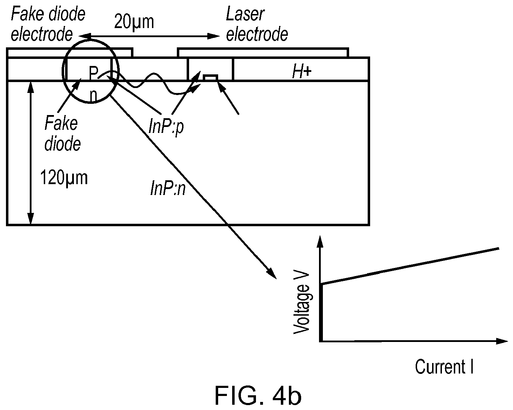

Referring to figure 4a, in the case of heating using surface resistance, a heating element 401 comprises a resistive heating element. The resistive heating element can be serpentine, as shown in figure 4 for example, or can be a strip/stripe of resistive material, such as a thin layer of NiCr for example. The heating element 401 is provided adjacent to the laser waveguide 403 of the laser 405. The heating element 401 heats (407) the laser electrode, thereby enabling thermal tuning.

In the alternative example shown in figure 4a, a fake diode 410 is used adjacent the laser waveguide 403 of the laser 405 as a heating element. Energising the electrode 411 of the diode 410 causes current to pass through the pn junction, which generates a voltage. By way of the Joule effect, the V.I energy produces heat 413 that heats the laser electrode, thereby enabling thermal tuning.

Figure 4b is a schematic representation of a fake diode implementation according to an example, as depicted in figure 4a (lower section). A PN diode, or PIN diode is provided as shown. However, the diode does not generate light, and is only used as an electrical circuit. It does not have the V(I) linear characteristic of resistor, but a characteristic with an initial voltage (as shown in the graph of figure 4b). Nevertheless, the effect is the same: when a current is injected, a voltage is produced on the diode. Since V x I corresponds to electrical power, the injected current effectively turns into heating via thermal resistance.

According to an example, the heating element can be used to generate a fast change of wavelength of the laser. The current applied to energise the heater element can then be progressively reduced (e.g. to zero) and heating is taken over with the thermoelectric device (e.g. a Peltier TEC). For heating, heating element current can be rapidly increased, then decreased while heat is progressively provided by TEC. For cooling, TEC current can be reduced and heating element current can be increased ahead of time, then heating element current can be abruptly reduced at tuning time.

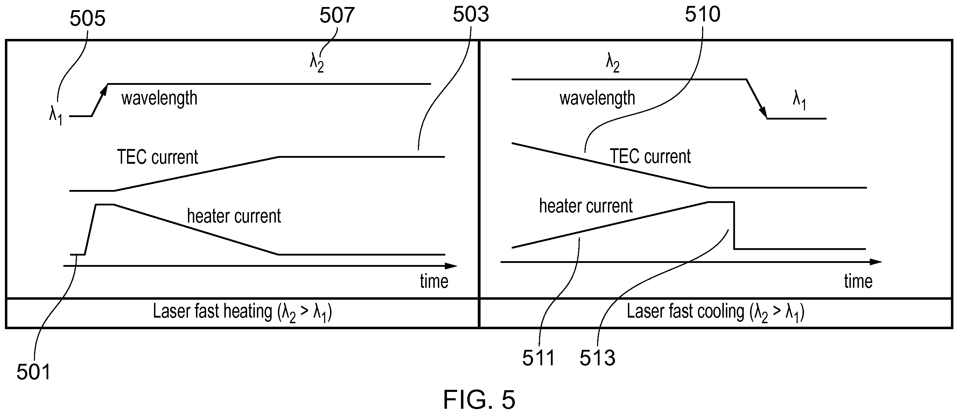

Figure 5 is a schematic representation of the principle of fast tuning according to an example. On the left-hand side of figure 5 is shown the relative heating profiles of a heating element and thermoelectric device when tuning from a lower (λ₁) to a higher wavelength (λ₂), whereas the right-hand side of figure 5 depicts the relative heating profiles of a heating element and thermoelectric device when tuning from a higher (λ₂) to a lower wavelength (λ₁).

As can be seen, referring to the left-hand side first of all, depicting fast heating according to an example, a sudden increase in current 501 to the heating element ('heater current') at steady (e.g. zero) TEC current 503 results in a jump in output of the laser device from λ₁ (505) to λ₂ (507). In order to maintain the wavelength output at λ₂, the TEC current is gradually increased over time as the heating element current is gradually decreased as depicted.

Thus, an operating temperature of a semiconductor laser can be modified using first (TEC) and second (heating element) heating devices. Referring to figure 5, the operating temperature can comprise first and second temperature components, wherein the first heating device is configured to modify the first component of the temperature of the semiconductor laser over a first time period, and wherein the second heating device is configured to modify the second component of the temperature of the semiconductor laser over a second time period. In an example, the second time period is less than the first time period. That is, the heating element can provide a short burst of heating (or suddenly switch off as depicted in figure 5 right-hand side for example), whereas the TEC can be used to provide a steady heating or cooling effect. Therefore, as depicted in figure 5 for example, the heating element can be used to provide a sudden increase or decrease in temperature over a short period of time compared to the more gradual increase or decrease in temperature provided by the TEC. As depicted in figure 5, the heating element can provide a gradual increase or decrease in temperature before or after the sudden 'burst' change. Alternatively, the rapid heating/cooling can be provided by way of an impulse type injection of current to the heating element without gradual increase or decrease either side.

Similarly, with reference to the right-hand side of figure 5, depicting fast cooling according to an example, the TEC current 510 is gradually decreased over time as the heating element current 511 is gradually increased as depicted. A sudden decrease in heating element current 513 to the heating element ('heater current') at the point that there is a steady (e.g. zero) TEC current results in a jump in output of the laser device from λ₂ to λ₁.

In an example, heating element energy is counterbalanced by the TEC, which aims to maintain a constant laser temperature, measured using a thermistor for example. Thus, the thermal energy provided by the heating element can be inefficiently dissipated towards the TEC, which reactively cools down the laser by way of the Peltier effect. Therefore, according to an example, laser / heating element thermal resistance (Rth) is degraded in order to maintain heat provided by heating element in the laser rather than dissipating it towards the TEC. Rth, in °C/W, represents the efficiency of heating: the temperature increase for a given injected power. Usually, it is desirable to keep this as low as possible to avoid laser self-heating. However, according to an example, thermal resistance is degraded (i.e. the value of Rth is increased).

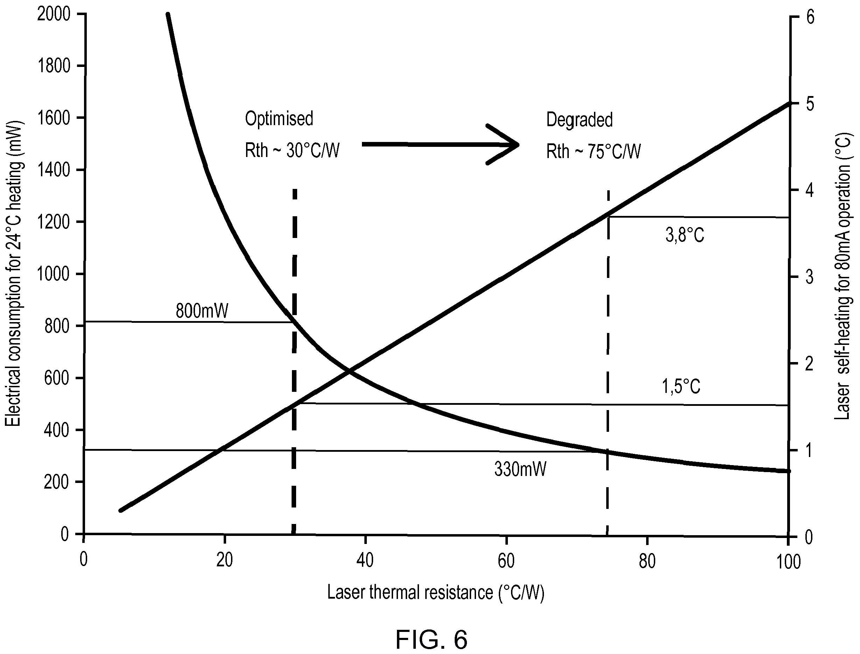

Figure 6 shows a graph depicting required electrical power to tune over 24°C (left axis) and laser self-heating in standard operation at 80mA (right axis) as a function of laser thermal resistance. With a typical optimised Rth of 30°C/W, 800mW are necessary. This value is too high, especially at it increases the thermal load on the TEC, which consequently sharply rises its consumption as well. When increasing Rth to 75°C/W, heating consumption is reduced to 330mW, which becomes an acceptable value and makes fast heating by heater possible.

The impact is to increase laser self-heating from 1.5 to 3.8°C, which is 2.3°C higher, and which can be compensated for by the TEC, or by designing the laser to operate a few degrees higher. In case of burst-mode operation, laser self-heating can be compensated by counter-heating to keep a constant emission wavelength. Self-heating is increased, but as counter-heating by heater efficiency is similarly increased, there is no impact on counter heating consumption.

In a typical laser assembly, the most efficient interface to degrade thermal resistance is between the laser semiconductor chip and the submount, as this small surface can act as a thermal bottleneck. Generally, the laser semiconductor chip is soldered to the submount by way a large AuSn pad, with efficient thermal dissipation. According to an example, in order to degrade thermal resistance, a mounting structure can be used. In an example, the mounting structure can be used to suspend the laser semiconductor chip above the sub-mount, thereby defining an air gap between the two. According to an example, the air gap can be provided by way of small AuSn or epoxy pads, bumps or by using grooves etched in the submount over which the laser chip is mounted. In an example, the dimensions of groove(s) or number of bumps are optimised to reach a Rth of about 80°C/W. Thus, in an example, a mounting structure can be small AuSn or epoxy pads, bumps or grooves etched in the submount over which the laser chip is mounted.

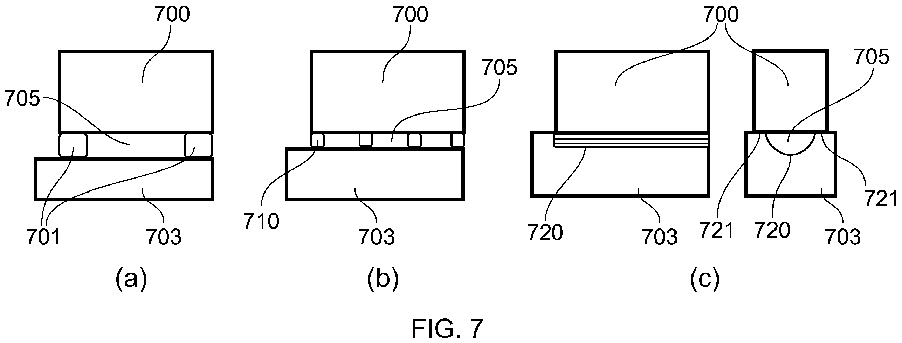

Figures 7a-c are schematic representations of examples of a mounting structure. In figure 7a is a side view of a laser semiconductor chip 700 mounted on AuSn or epoxy pads 701 that are mounted on the sub-mount 703 of a laser assembly. The air gap 705 is defined as a result of the elevation of the laser semiconductor chip 700 above the sub-mount 703.

In figure 7b, multiple Au bumps 710, which are generally smaller than the pads of figure 7a, are shown. As the bumps are smaller, more can be used in order to provide sufficient support for the chip 700.

In figure 7c, side and front views are depicted. A groove 720 in the sub-mount 703 is shown, defining an air gap 705 underneath the chip 700. Referring to the front view (right-most image of figure 7c), the groove is so etched as to define edge regions 721 in the sub-mount 703 to support the chip 700.

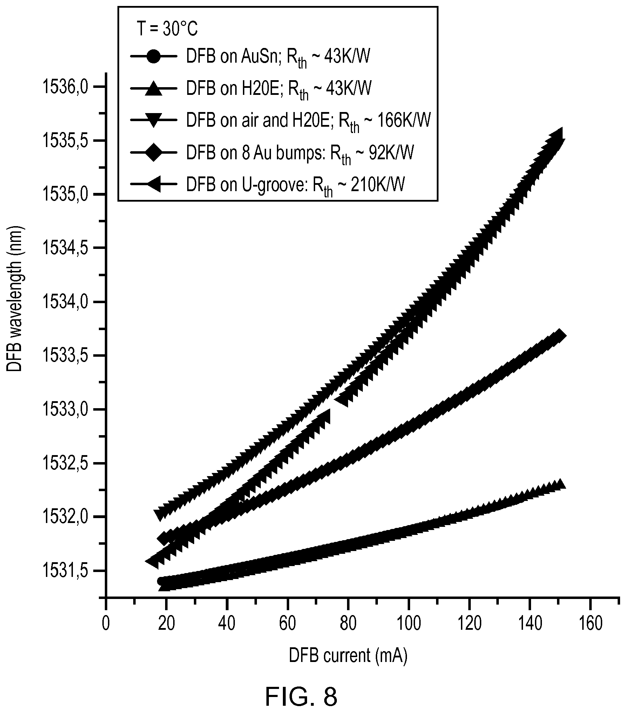

Figure 8 is a graph depicting variation of laser wavelength drift as a function of injected current for different mounting structures according to examples. The slope is representative of tuning efficiency, inversely proportional to thermal resistance Rth. Results in Figure 7 show, for an injected current increased from 20 to 140mA, similar tuning of about 1nm for AuSn or H20E continuous pad, corresponding to Rth∼43°C/W
- about 1.5nm for 8 Au bumps, corresponding to Rth∼92°C/W
- about 3.3nm for H20E pads, corresponding to Rth∼166°C/W
- about 4nm for U-grooves, corresponding to Rth∼210°C/W.

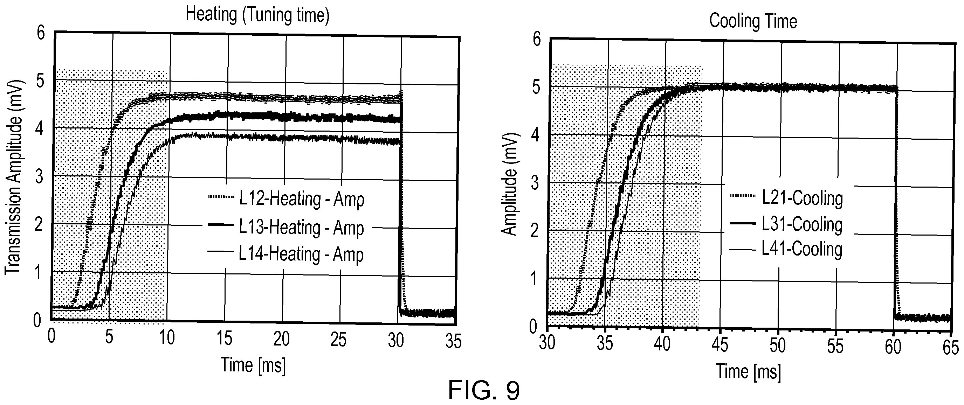

A laser with 6 Au bumps has been packaged in a butterfly module and tested. As shown Figure 9, 2.4nm tuning with only 330mW injected power into a heating element according to an example (Rth=73°C/W), instead of IW for a similar module with a standard AuSn pad. Fast tuning was tested by applying a square signal to the heating element, and measuring output power through the edge of a narrow filter. Heating and cooling times shorter than 13ms with better than 4GHz accuracy were obtained. This enables class B applications (<25ms) to be realised with a heater power consumption divided by 3 (< 330mW).

The present inventions can be embodied in other specific apparatus and/or methods. The described embodiments are to be considered in all respects as illustrative and not restrictive. In particular, the scope of the invention is indicated by the appended claims rather than by the description and figures herein. All changes that come within the meaning and range of equivalency of the claims are to be embraced within their scope. Although the above has been described with reference to a directly modulated laser (DML), it could equally be implemented to the laser section in an externally modulated laser (EML) for example.

## Claims

1. A laser assembly comprising:
a semiconductor laser mounted on a sub-mount;
a heating element;
a thermoelectric device; and
a mounting structure to receive the semiconductor laser, the mounting structure disposed between the semiconductor laser and the thermoelectric device to reduce a thermal conductivity between the semiconductor laser and the thermoelectric device.

2. A laser assembly as claimed in claim 1, wherein the mounting structure defines an air gap between the semiconductor laser and the sub-mount, thereby reducing thermal conductivity between the semiconductor laser and the thermoelectric device.

3. A laser assembly as claimed in claim 1 or 2, wherein the mounting structure comprises multiple thermally conductive protrusions extending from the sub-mount.

4. A laser assembly as claimed in claim 1 or 2, wherein the mounting structure comprises at least one indentation in the sub-mount, at least an edge of which is configured to support the semiconductor laser.

5. A laser assembly as claimed in any preceding claim, wherein the heating element comprises a resistive heating element.

6. A laser assembly as claimed in any of claims 1 to 4, wherein the heating element comprises a diode.

7. A laser assembly as claimed in any preceding claim, wherein the thermoelectric device comprises a Peltier device.

8. A laser assembly as claimed in any preceding claim, wherein the heating element is provided in a waveguide of the semiconductor laser.

9. A laser assembly as claimed in any preceding claim, further comprising a temperature sensor to measure a temperature of the semiconductor laser or sub-mount.

10. A method for tuning a modulated laser assembly, the method comprising:
modifying an operating temperature of a semiconductor laser of the laser assembly using first and second heating devices, the operating temperature comprising first and second temperature components, wherein the first heating device is configured to modify the first component of the temperature of the semiconductor laser over a first time period, and wherein the second heating device is configured to modify the second component of the temperature of the semiconductor laser over a second time period.

11. The method as claimed in claim 10, wherein the second time period is less than the first time period.

12. The method as claimed in claim 10 or 11, further comprising modifying the first component of the temperature of the semiconductor laser using a thermoelectric device.

13. The method as claimed in any of claims 10 to 12, further comprising modifying the second component of the temperature of the semiconductor laser using a heating element arranged on the semiconductor laser.

14. The method as claimed in any of claims 10 to 13, further comprising using a temperature sensor to measure the operating temperature of the semiconductor laser.

15. The method as claimed in claim 14, further comprising varying a current supply to the first and/or second heating devices so as to modify a heating output thereof.
